# EUROPEAN PATENT APPLICATION

(11) **EP 2 234 140 A2**
(43) Date of publication of application: **29.09.2010**
(21) Application number: 10157944.9
(22) Date of filing: 26.03.2010
(51) Int. Cl.: H01J 37/32

(54) **Plasma processing apparatus**

(30) Priority: 27.03.2009 JP 2009079256
(71) Applicant: Tokyo Electron Limited, Tokyo 107-6325 (JP)
(72) Inventor: Yamawaku, Jun, Yamanashi 407-0192 (JP); Koshimizu, Chishio, Yamanashi 407-0192 (JP)
(74) Representative: HOFFMANN EITLE

(57) **Abstract**

A plasma processing apparatus performs plasma processing on a processing target in a processing chamber. The apparatus includes: an object to be heated provided near a periphery of a mounting table (110a) disposed in the processing chamber; and a heating electrode (135) disposed adjacent to the periphery of the mounting table, for heating the object to be heated. A first coil (135a1) having a first path and a second coil (135a2) having a second path are wired close to each other in the heating electrode along the periphery of the mounting table.

## Description

The present invention relates to a plasma processing apparatus for performing plasma processing on a processing target; and, more particularly, to control of electromagnetic induction heating in the plasma processing apparatus.

When a processing target is plasma-processed, it is important to control the ambient temperature of the processing target. For example, during an etching process, an etching rate and a width or a depth of a groove formed in the processing target vary depending on the change in the ambient temperature of the processing target. Therefore, in order to perform desired fine processing on the processing target, it is required to accurately control the temperature of a mounting table for mounting thereon the processing target and the ambient temperature thereof.

Therefore, a temperature control mechanism such as a heater, a cooling circuit or the like is built in the mounting table to control the processing target mounted thereon to a desired temperature. Further, a focus ring made of, e.g., silicon, is provided to surround a peripheral portion of the processing target mounted on the mounting table. By heating the focus ring, characteristics of an outermost peripheral portion of the processing target, i.e., a wafer, are controlled and in-plane uniformity of processing of the processing target is improved (see, e.g., Japanese Patent Application Publication No. 2008-159931).

Referring to Japanese Patent Application Publication No. 2008-159931, a focus ring heating electrode is disposed at a peripheral portion of the mounting table, and an annular induction heating element made of metal is provided in the focus ring while facing the heating electrode. By applying a bias voltage to the heating electrode and allowing a current to flow in an annular coil in the heating electrode, an induced magnetic field is generated around the coil. The induced magnetic field generated from the coil intersects the annular induction heating element facing the heating coil and generates an eddy current in the induction heating element. Thus, the induction heating element is inductively heated. As a result, the focus ring is controlled to a predetermined temperature.

[Patent Document 1] Japanese Patent Laid-open Publication No. 2008-159931

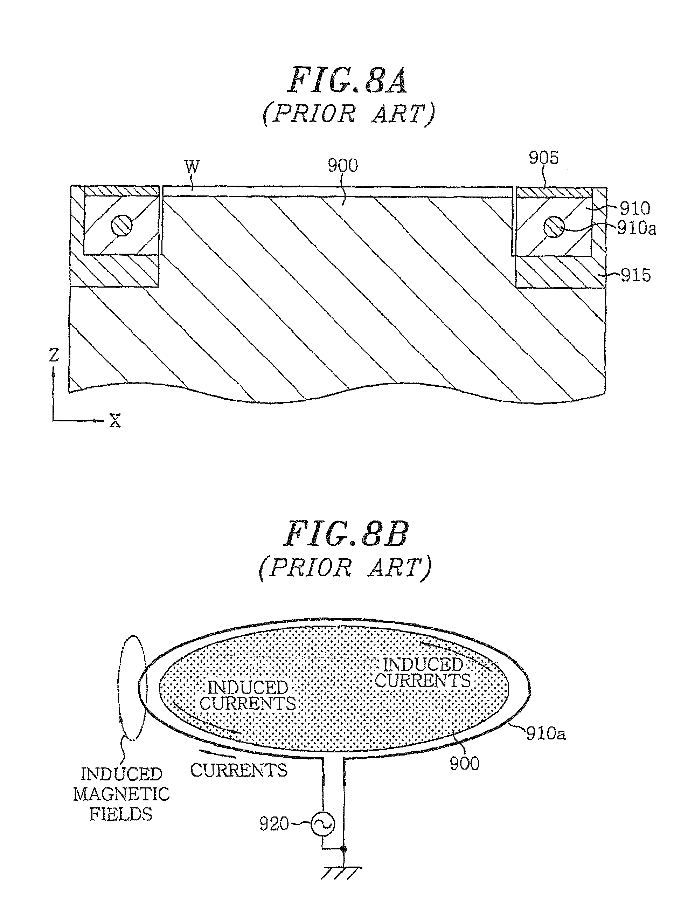

Fig. 8A shows a schematic view around a mounting surface of a mounting table 900. A heating electrode 910 is disposed directly below a focus ring 905 to surround a peripheral portion of the mounting table 900 for mounting thereon a wafer W serving as a processing target. Further, a dielectric material 915 such as quartz or the like is provided to surround the heating electrode 910 under the bottom and around the outer periphery thereof.

When a coil 910a provided in the heating electrode 910 is supplied with power, an induced magnetic field is generated by the coil 910a as shown in Fig. BE, and the focus ring 905 disposed directly above the heating electrode 910 is heated.

However, the induction field generates an induced current (eddy current) shown in Fig. 8B in the vicinity of the peripheral portion of the mounting table 900 disposed near the heating electrode 910. The eddy current generates Joule heat according to an inherent resistance of metal forming the mounting table 900, so that the peripheral portion of the mounting table 900 is heated. As a result, the peripheral portion of the wafer W is excessively heated, and characteristics of the outermost peripheral portion of the wafer W deteriorate.

In view of the above, the present invention provides a plasma processing apparatus capable of performing on a selective heating target object induction heating.

In accordance with a first aspect of the present invention, there is provided a plasma processing apparatus for performing plasma processing on a processing target in a processing chamber.

The plasma processing apparatus includes: an object to be heated provided near a periphery of a mounting table disposed in the processing chamber; and a heating electrode disposed adjacent to the periphery of the mounting table, for heating the object to be heated.

In the plasma processing apparatus, a first coil having a first path and a second coil having a second path are wired close to each other in the heating electrode along the periphery of the mounting table.

The first coil and the second coil are wired close to each other in the heating electrode. Further, a voltage is applied to allow currents to flow in the first coil and the second coil in opposite directions. Therefore, the induced magnetic field generated around the first coil and that generated around the second coil have opposite directions. Hence, the induced magnetic fields of the directions that affect the mounting table are offset, and no eddy current is generated in the mounting table. As a result, the induction heating of the mounting table can be prevented.

Meanwhile, the object to be heated and the heating electrode are located adjacent to each other, so that the induced magnetic field reaches the object to be heated and generates an induced current in the object to be heated. Accordingly, the object to be heated can be selectively heated, and this can improve accuracy of the plasma processing of the object to be processed.

In accordance with a second aspect of the present invention, there is provided a plasma processing apparatus for performing plasma processing on a processing target in a processing chamber.

The plasma processing apparatus includes: an object to be heated provided near a periphery of an upper electrode disposed in the processing chamber; and a heating electrode disposed adjacent to the periphery of the upper electrode, for heating the object to be heated.

In the plasma processing apparatus, a first coil having a first path and a second coil having a second path are wired close to each other in the heating electrode along the periphery of the upper electrode.

In accordance with a third aspect of the present invention, there is provided a heating electrode provided close to an object to be heated near a periphery of a mounting table installed in a plasma processing apparatus.

In the heating electrode, a first coil having a first path and a second coil having a second path are wired adjacent to each other along the periphery of the mounting table to heat the object to be heated.

As described above, in accordance with the aspects of the present invention, an object to be heated can be selectively inductively heated.

The objects and features of the present invention will become apparent from the following description of embodiments, given in conjunction with the accompanying drawings, in which:
Fig. 1 is a vertical cross sectional view showing an entire configuration of a plasma processing apparatus in accordance with a first embodiment of the present invention;
Figs. 2A and 2B show an internal configuration and induction heating of a heating electrode in accordance with the first embodiment of the present invention;
Figs. 3A to 3C illustrate other examples of the heating electrode in accordance with the first embodiment of the present invention;
Fig. 4 depicts a modification of arrangement of the heating electrode in accordance with the first embodiment of the present invention;
Figs. 5A and 5B describe an example of a method for supplying power to the heating electrode;
Figs. 6A and 6B present an example of a method for supplying power to the heating electrode;
Fig. 7 is a vertical cross sectional view showing an entire configuration of a plasma processing apparatus in accordance with a second embodiment of the present invention; and
Figs. 8A and 8B explain induction heating of a conventional heating electrode.

The embodiments of the present invention will be described with reference to the accompanying drawings which form a part hereof. Further, like reference numerals will be given to like parts having substantially the same functions throughout the specification and the drawings, and redundant description thereof will be omitted.

### <First embodiment>

### (Entire configuration of plasma processing apparatus)

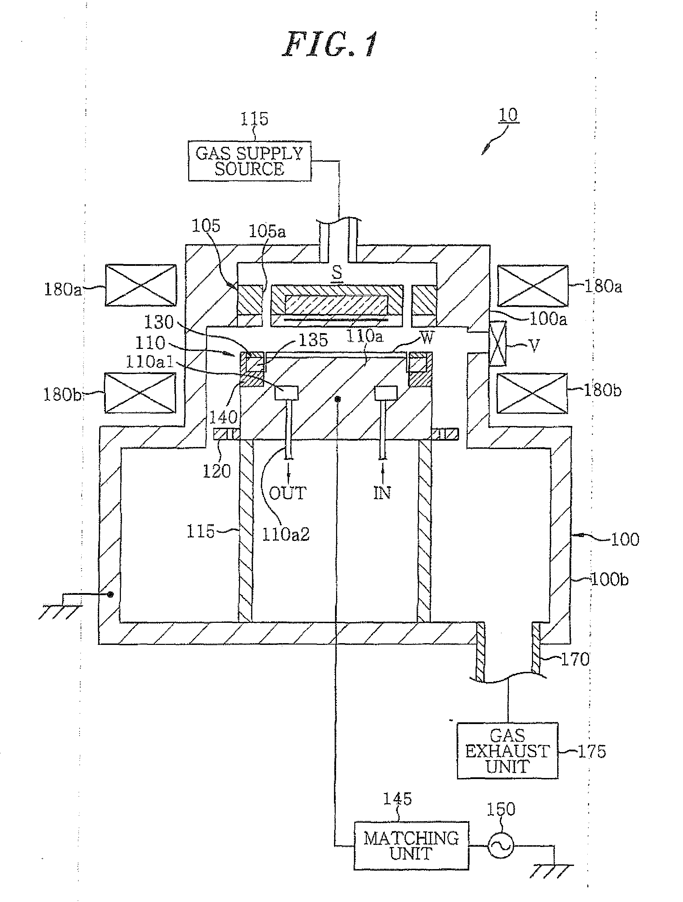

Hereinafter, an entire configuration of a plasma processing apparatus in accordance with a first embodiment of the present invention will be described with reference to Fig. 1. Fig. 1 shows a Reactive Ion Etching (RIE) plasma etching apparatus (parallel plate-type plasma processing apparatus) 10 as an example of a plasma processing apparatus for performing plasma processing on a processing target in a processing chamber.

The RIE plasma etching apparatus 10 includes a processing chamber 100 in which a wafer W loaded through a gate valve W is plasma-processed. The processing chamber 100 is formed with an upper cylindrical chamber 100a having a small diameter and a lower cylindrical chamber 100b having a relatively large diameter. The processing chamber 100 is made of metal, e.g., aluminum or the like, and is grounded.

An upper electrode 105 and a lower electrode 110 are disposed in the processing chamber 100 to be faced each other and form a pair of parallel plate electrodes. The upper electrode 105 has an alumina sprayed surface and a plurality of gas openings 105a penetrating therethrough to thereby serve as a shower plate.

A gas supplied from a gas supply source 115 is diffused in a gas diffusion space S in the processing chamber 100 and then introduced into the processing chamber 100 through the gas openings 105a. In Fig. 1, the gas openings 105a are formed only at a peripheral portion of the upper electrode 105. However, the gas openings 105a are also formed at a central portion thereof.

The lower electrode 110 serves as an electrode to which a high frequency power is applied, and also serves as a mounting table 110a for mounting thereon a wafer W. The mounting table 110a is made of metal such as aluminum or the like and supported by a support member 115 via an insulator (not shown). Thus, the lower electrode 110 is in an electrically floating state. A baffle plate 120 is provided at a lower peripheral portion of the mounting table 110a to control gas flow.

A coolant path 110a1 is formed in the mounting table 110a. A coolant introduced from an inlet side of a coolant introduction line 110a2 circulates in the coolant path 110a1 and then is discharged from an outlet side of the coolant introduction line 110a2. Accordingly, the mounting table 110a is controlled at a desired temperature.

An annular focus ring 130 made of, e.g., silicon, is disposed to surround the mounting table 110a and serves to maintain uniformity of a plasma. The focus ring 130 is an example of an object to be heated which is provided near the periphery of the mounting table 110a installed in the processing chamber 100.

The heating electrode 135 is disposed directly below the focus ring 130 and near the periphery of the mounting table 110a, and inductively heats the focus ring 130. The peripheral side surfaces of the focus ring 130 and the heating electrode 135, and a bottom surface of the heating electrode 135 are covered by an insulation member 140.

The mounting table 110a is connected to a matching unit 145 and a high frequency power supply 150. The gas in the processing chamber 100 is excited by energy of an electric field of a high frequency of, e.g., 13.56 MHz, output from the high frequency power supply 150. The wafer W is etched by a discharge plasma thus generated.

A gas exhaust port 170 is disposed at a bottom surface of the processing chamber 100. By operating a gas exhaust unit 175 connected to the gas exhaust port 170, the interior of the processing chamber 100 can be maintained in a required vacuum state. Multi-pole ring magnets 180a and 180b are provided around the periphery of the upper chamber 100a. Each of the multi-pole ring magnets 180a and 180b has a plurality of columnar anisotropic segment magnets attached to a casing of an annular magnetic body, and the multiple columnar segment magnets are arranged such that poles of adjacent segment magnets face opposite directions.

Accordingly, magnetic force lines are formed between the adjacent segment magnets, and a magnetic field is generated only at a peripheral portion of a processing space between the upper electrode 105 and the lower electrode 110. As a result, the plasma is confined within the processing space.

### (Internal configuration of heating electrode)

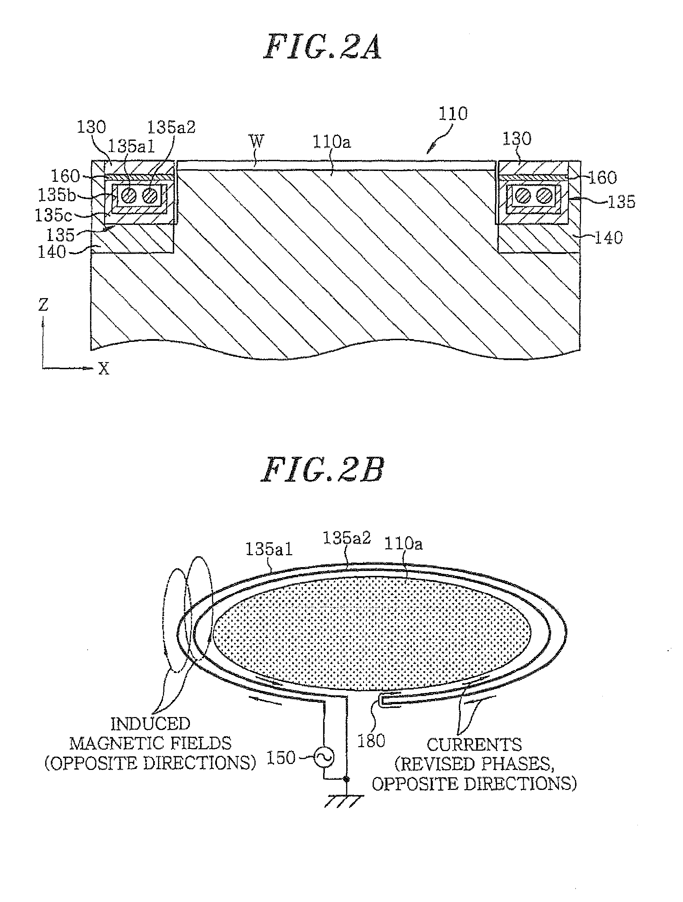

Hereinafter, an internal configuration of a heating electrode 135 will be described with reference to Figs. 2A and 2B. As can be seen from a vertical cross section of the heating electrode 135 in Fig. 2A, the heating electrode 135 is formed in an annular shape near the peripheral portion of the mounting table 110a. The focus ring 130 is provided above the heating electrode 135.

A heating medium 160 having a resistance greater than that of the focus ring 130 is provided between the focus ring 130 and the heating electrode 135. In this embodiment, the focus ring 130 is made of Si, and the heating medium 160 is made of SiC. In a case where the focus ring 130 is made of a material having a resistance higher than a specific value and is easily inductively heated, the focus ring 130 may be disposed directly above the heating electrode 135 without providing the heating medium 160.

The heating electrode 135 includes a forwarding coil 135a1 and a returning coil 135a2, a highly permeable member 135b and a protection member 135c. Figs. 2A and 2B schematically show a wiring state of the coils 135a1 and 135a2. The forwarding coil 135a1 and the returning coil 135a2 are wired close to each other in an inner central portion of the heating electrode 135 along the periphery of the mounting table 110a.

The forwarding coil 135a1 travels around the periphery of the mounting table 110a and then travels, as the returning coil 135a2, around the periphery of the mounting table 110a in a reverse direction. Namely, the forwarding coil 135a1 and the returning coil 135a2 are double loops formed with a single coil. The single coil travels around the periphery of the mounting table 110a to make a first loop, and returns from a turning portion 180 to make a second loop around the periphery of the mounting table 110a.

In this manner, the double-coiled heating electrode 135 is formed. The forwarding coil 135a1 is an example of a coil of a first path, and the returning coil 135a2 is an example of a coil of a second path. Moreover, the coils 135a1 and 135a2 are made of metal such as tungsten, titanium or the like.

Provided in the heating electrode 135 is the highly permeable member 135b for partitioning the outgoing and the returning coil 135a1 and 135a2 from the mounting table 110a. In this embodiment, the highly permeable member 135b is made of aluminum. However, it is not limited thereto and may also be made of a dielectric material such as alumina, quartz or the like, or metal having high magnetic permeability which serves as a member for shielding a leakage magnetic field.

A material having high magnetic permeability is characterized in that a magnetic field can easily pass therethrough. In other words, the magnetic field is absorbed in the material having high magnetic permeability. In the heating electrode 135 in accordance with this embodiment, the highly permeable member 135b covers the mounting table 110a side near the outgoing and the returning coil 135a1 and 135a2 and is opened toward the focus ring 130 side.

Accordingly, the magnetic fields from the outgoing and the returning coil 135a1 and 135a2 are confined within the highly permeable member 135b without being leaked to outer side surfaces and a bottom surface of the outgoing and the returning coil 135a1 and 135a2. As a consequence, an induced magnetic field to be described later is canceled, and a leakage magnetic field is not generated at the mounting table 110a side. Meanwhile, since the highly permeable member 135b is opened to the focus ring 130 side, the induced magnetic fields of the outgoing and the returning coil 135a1 and 135a2 are generated at the focus ring 130 side.

The outgoing and the returning coil 135a1 and 135a2 and the highly permeable member 135b are covered by the protection member 135c without being exposed in the processing chamber. The coils 135a1 and 135a2 are made of metal, so that the exposure of the coils 135a1 and 135a2 in the processing chamber causes metal contamination.

Further, if the coils 135a1 and 135a2 and the highly permeable member 135b are exposed to a plasma or a corrosive gas, the coils 135a1 and 135a2 are corroded and deteriorated. To that end, the coils 135a1 and 135a2 and the highly permeable member 135b are entirely covered by the protection member 135c made of a dielectric material such as quartz, alumina, Teflon (Registered Trademark) or the like. A space between the coils 135a1 and 135a2 and the highly permeable member 135b is maintained in a vacuum state. An insulating material may fill this space.

### (Induction heating)

In this embodiment, only the focus ring 130 is inductively heated by the heating electrode 135, and members such as the mounting table 110a disposed near the heating electrode 135 and the like are not inductively heated. Before explaining the reason thereof, the induction heating of the conventional focus ring will be briefly explained.

Fig. 8A illustrates the heating electrode 910 in which the coil 910a is wired one round around the periphery of the mounting table 900. When a current flows in the coil 910a by the output of the high frequency power supply 920, an induced magnetic field is generated around the coil 910a as illustrated in Fig. 8B. Due to this magnetic field, an induced current (eddy current) is generated in the focus ring 905 provided directly above the heating electrode 910, so that Joule heat according to a resistance of metal forming the focus ring 905 is generated. As a result, the focus ring 905 is heated.

However, due to this induced magnetic field, an induced current (eddy current) is also generated in the peripheral portion of the mounting table 900 which is adjacent to the heating electrode 910, so that the peripheral portion of the mounting table 900 is heated. Accordingly, the peripheral portion of the wafer W is excessively heated, whereby characteristics of the outermost peripheral portion of the wafer W deteriorate.

### (Selective induction heating)

Hence, in this embodiment, there is provided a heating electrode 135 which prevents induction heating of the mounting table 110a so as not to affect processing such as etching or the like. As shown in Fig. 2B, a current flows, at an instant, in the forwarding coil 135a1 in, e.g., a clockwise direction by applying a voltage from the high frequency power supply 150 thereto. On the other hand, a current flows, at the same instant, in the returning coil 135a2 in a counterclockwise direction.

Namely, the currents flow in opposite directions in the outgoing and the returning coil 135a1 and 135a2 adjacent to each other. If the phases of the currents flowing in the coils 135a1 and 135a2 are opposite, the directions of the induced magnetic fields generated around the coils 135a1 and 135a2 are also opposite to each other. Accordingly, the induced magnetic fields of the forwarding coil 135a1 and the returning coil 135a2 are offset by each other.

Meanwhile, the focus ring 130 and the heating electrode 135 are disposed adjacent to each other via the heating medium 160. Therefore, the inducted magnetic fields generated around the coils 135a1 and 135a2 reach the heating medium 160 and generate an eddy current in the heating medium 160 to thereby heat the heating medium 160. As a result, the focus ring 130 is heated via the heating medium 160 by radiant heat.

Namely, by forming a coil shaping double loops and allowing currents having revised phases to flow in the respective loops in opposite directions, only the focus ring 130 can be selectively inductively heated while preventing inductively heating the mounting table 110a. Accordingly, characteristics of the outermost peripheral portion of the wafer W can be controlled, and the entire wafer W can be etched with high precision.

### <Modification of heating electrode >

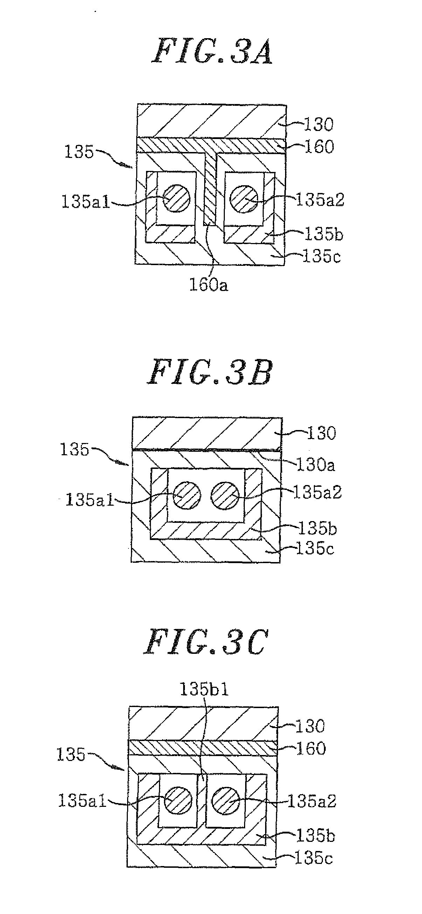

Hereinafter, modifications of the first embodiment will be described with reference to Figs. 3A to 3C. Referring to Fig. 3A, an annular protrusion 160a which protrudes between the forwarding coil 135a1 and the returning coil 135a2 is provided at the heating medium 160. With this configuration, the heating medium 160 becomes closer to the outgoing and the returning coil 135a1 and 135a2. Therefore, the induction heating of the heating medium 160 can be more effectively performed, and the heating efficiency of the focus ring 130 can be improved.

Referring to Fig. 3B, the heating medium 160 is formed as a single unit with the focus ring 130 at a rear surface 130a thereof (the surface facing the heating electrode 135). The rear surface 130a of the focus ring 130 is sputtered with metal that is easily heated by an induced magnetic field, e.g., titanium, tungsten, cobalt, nickel or the like, and is heated to make a silicide.

Namely, by making the rear surface 130a of the focus ring 130 a silicide of, e.g., Si₂Ti, Si₃W, Si₂Co, Si₂Ni or the like, the rear surface 130a functions as the heating medium 160, and adhesivity between the focus ring 130 and the heating electrode 135 increases. Hence, the induction heating of the focus ring 130 can be more effectively carried out.

As can be seen from Fig. 3C, the annular protrusion 135b1 which protrudes between the forwarding coil and the returning coil 135a1 and 135a2 may be provided at the highly permeable member 135b. Hence, the magnetic fields generated from the coils 135a1 and 135a2 can be further prevented from leaking to the mounting table 110a side. Although it is preferable to provide the highly permeable member 135b in order to prevent the magnetic field from leaking to the mounting table 110a, the highly permeable member 135b may not be provided at the heating electrode 135 unlike in the above example.

### <Arrangement of heating electrode>

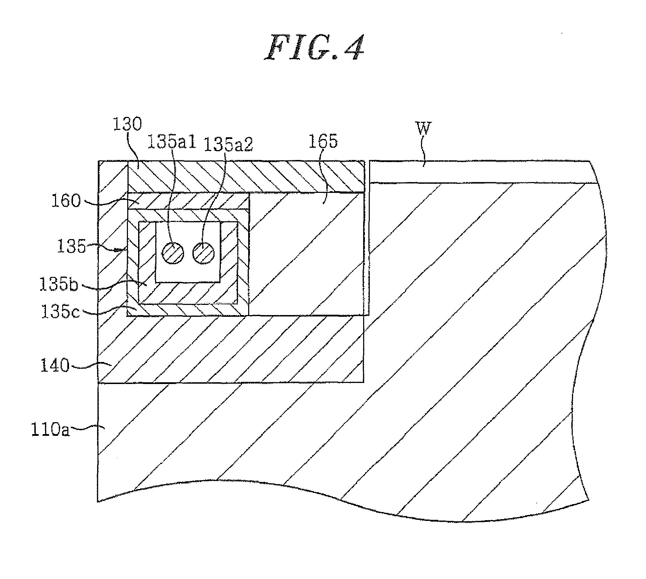

Hereinafter, an example of arrangement of the heating electrode 135 will be described. Referring to Fig. 4, a temperature control member 165 is inserted between the heating electrode 135 and the mounting table 110a, instead of providing the heating electrode 135 near the mounting table 110a. The temperature control member 165 is made of, e.g., aluminum or alumina.

In that case as well, the focus ring 130 is adhered to the heating electrode 135 via the heating medium 160 and thus is inductively heated. Further, the temperature of the outermost peripheral portion of the focus ring 130 can be easily controlled due to the insertion of the temperature control medium 165 into the mounting table 110a and the offset of the induced magnetic fields generating at the coils 135a1 and 135a2.

In addition, the temperature control member 165 may be heated or cooled by a coolant or the like (not shown). Or, two or more temperature control members 165 may be provided. In that case, the temperature control can be performed by heating a part of the temperature control members 165 and cooling another part of the temperature control members 165.

### <Power supply unit>

Hereinafter, units for supplying power to the coils 135a1 and 135a2 in the heating electrode 135 will be described. The outgoing and the returning coil 135a1 and 135a2 are connected to one of a high frequency power supply for plasma generation and a high frequency power supply for bias provided and an additional power supply provided in the RIE plasma etching apparatus 10 to be supplied with power from the connected power supply.

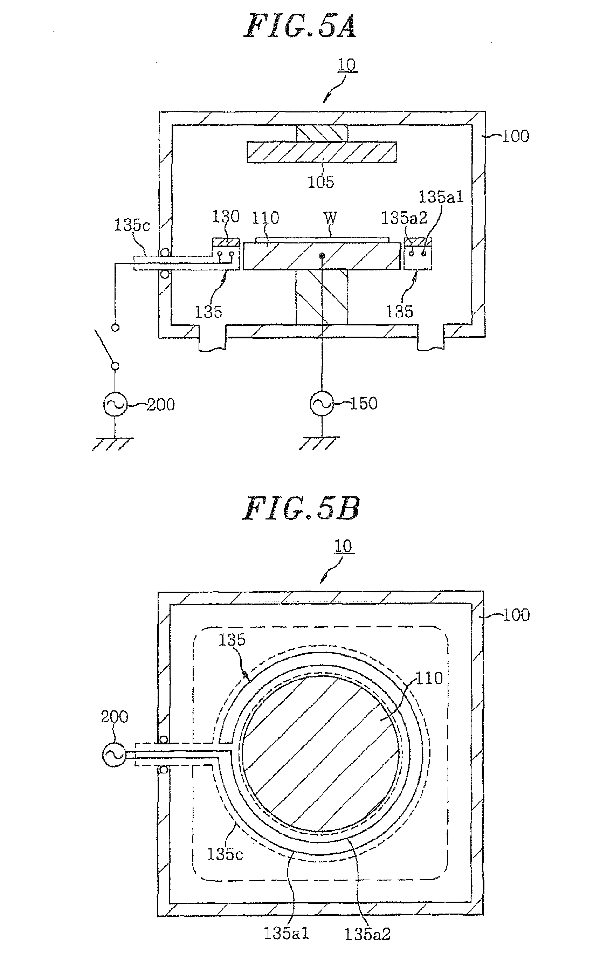

Fig. 5A illustrate a schematic vertical cross section of the RIE plasma etching apparatus 10, and Fig. 5B depicts a schematic horizontal cross section of the mounting table 110a and the heating electrode 135. Referring to Figs. 5A and 5B, the outgoing and the returning coil 135a1 and 135a2 penetrate the sidewall of the processing chamber 100 while being covered by the protection member 135c. The coils 135a1 and 135a2 are connected to an AC power supply 200 additionally provided outside the processing chamber 100. By covering the outgoing and the returning coil 135a1 and 135a2 with the protection member 135c such as quartz or the like to the outside of the processing chamber 100, it is possible to prevent generation of abnormal discharge in the processing chamber 100 due to the coils functioning as terminals.

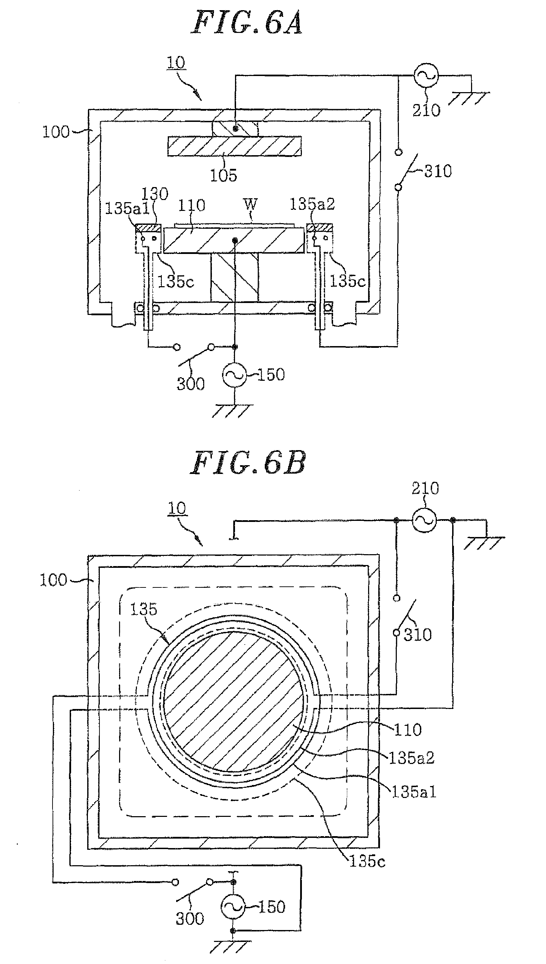

Fig. 6A shows a vertical cross section of the RIE plasma etching apparatus 10, and Fig. 6B describes a horizontal cross section of the mounting table 110a and the heating electrode 135. Referring to Figs. 6A and 6B, the coils 135a1 and 135a2 are divided into an outer peripheral coil 135a1 and an inner peripheral coil 135a2.

In other words, the outer peripheral coil 135a2 is an example of a coil having a first path, and the inner peripheral coil 135a2 is an example of a coil having a second path. The coils 135a1 and 135a2 penetrate the bottom wall of the processing chamber 100 while being covered by the protection member 135c. Voltages are applied so that currents having revised phases flow in opposite directions in the outer peripheral coil 135a1 and the inner peripheral coil 135a2.

The outer peripheral coil 135a1 is connected to a high frequency power supply for bias 150 via a switch 300. The inner peripheral coil 135a2 is connected to a high frequency power supply for plasma generation 210 via a switch 310. When the high frequency power supply for bias 150 is used as a power supply, the application of the high frequency power to the lower electrode 110 and the coil 135a1 is switched by the switch 300. For example, a bias voltage is applied to the lower electrode 110 during an etching process, and that is applied to the heating electrode 135 during processing other than etching.

In the similar manner, when the high frequency power supply for plasma generation 210 is used as a power supply, the application of the high frequency power to the upper electrode 105 and the coil 135a2 is switched by the 310. For example, a voltage is applied to the heating electrode 135 during processing other than etching, and that is applied to the upper electrode 105 during an etching process. When the power of a high frequency of, e.g., 13.56 MHz, is applied, preliminary heating of the focus ring 130 can be quickly carried out. By preliminarily heating the focus ring, etching accuracy of the outermost peripheral portions of the wafer W can be improved during consecutive processing of wafers W in which the wafers W are processed sequentially from a first wafer W to a last wafer W.

Before starting the processing, the switches 300 and 310 are switched on, and the focus ring 130 is preliminarily heated. During the processing, the switches 300 and 310 are switched off. The temperature of the focus ring 130 can be finely controlled by connecting the switch 310 even during the processing.

### <Second embodiment>

### (Entire configuration of plasma processing apparatus)

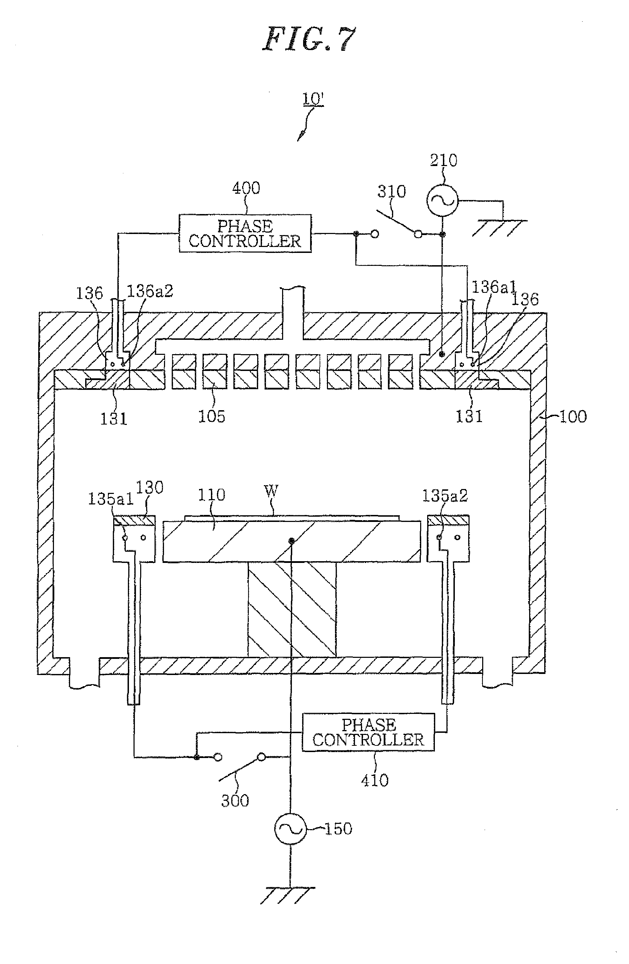

Hereinafter, an entire configuration of a plasma processing apparatus in accordance with a second embodiment of the present invention will be described with reference to Fig. 7. Fig. 7 shows an RIE plasma etching apparatus 10'. As in the first embodiment, a heating electrode 135 is provided directly below a focus ring 130.

Further, in the RIE plasma etching apparatus 10' in accordance with the second embodiment, an annular object to be heated 131 is provided near a periphery of an upper electrode 105 provided in a processing chamber 100. In that case as well, a heating electrode 136 is adhered to the object to be heated 131 near the periphery of the upper electrode 105, so that the object to be heated 131 is inductively heated. In the heating electrode 136, an outgoing and a returning coil 136a1 and 136a2 are wired close to each other along the periphery of the upper electrode 105.

A phase controller 400 is provided to control currents, which flow the coils 136a1 and 136a2, to have revised phases and opposite directions. Hence, a silicon portion (the object to be heated 131) provided at a peripheral portion of a ceiling plate can be selectively inductively heated. Further, a phase controller 410 is also provided to control currents, which flow the coils 135a1 and 135a2 in a heating electrode 135, to have revised phases and opposite directions.

In accordance with the above-described embodiments, a desired heating target portion can be selectively heated by suppressing induction heating caused by a leakage magnetic field generated near the heating electrode 135.

The present invention is not limited to the configuration described above. For example, the heating electrode of the present invention may include one or more pairs of coils, each pair including a first path coil and a second path coil reciprocating therein. The induced magnetic fields generated around the coils toward the mounting table can be canceled by providing an even number of coils adjacent to each other inside the heating electrode.

In the above-described embodiments, an RIE plasma etching apparatus has been described as an example of a plasma processing apparatus. However, the present invention is not limited thereto, and may also be applied to another plasma processing apparatus, e.g., a film forming apparatus or the like.

While the invention has been shown and described with respect to the embodiments, it will be understood by those skilled in the art that various changes and modification may be made without departing from the scope of the invention as defined in the following claims.

## Claims

1. A plasma processing apparatus for performing plasma processing on a processing target in a processing chamber, comprising:
an object to be heated provided near a periphery of a mounting table disposed in the processing chamber; and
a heating electrode disposed adjacent to the periphery of the mounting table, for heating the object to be heated,
wherein a first coil having a first path and a second coil having a second path are wired close to each other in the heating electrode along the periphery of the mounting table.

2. The plasma processing apparatus of claim 1, wherein a voltage is applied to allow currents to flow in the first coil and the second coil in opposite directions.

3. The plasma processing apparatus of claim 1 or 2,
wherein the first coil and the second coil are connected to each other at a turning portion to form a single coil.

4. The plasma processing apparatus of any one of claims 1 to 3, wherein the heating electrode has therein a highly permeable member for partitioning the first coil and the second coil from the mounting table.

5. The plasma processing apparatus of claim 4, wherein the highly permeable member covers the mounting table near the first coil and the second coil and is opened to the object to be heated side.

6. The plasma processing apparatus of any one of claims 1 to 5, wherein the first coil and the second coil are covered by a protection member.

7. The plasma processing apparatus of any one of claims 1 to 6, wherein a heating medium having a resistance greater than that of the object to be heated is provided between the object to be heated and the heating electrode.

8. The plasma processing apparatus of claim 7, wherein the heating medium protrudes between the first coil and the second coil.

9. The plasma processing apparatus of any one of claims 1 to 6, wherein a heating medium is formed on a surface of the object to be heated, the surface facing the heating electrode.

10. The plasma processing apparatus any one of claims 1 to 9, wherein a temperature control member is inserted between the heating electrode and the mounting table.

11. The plasma processing apparatus of any one of claims 1 to 10, wherein one or more pairs of the first coil and the second coil reciprocate in the heating electrode.

12. The plasma processing apparatus of any one of claims 1 to 11, wherein each of the first coil and the second coil is connected to at least one of a high frequency power supply for plasma generation and a high frequency power supply for bias and an additional power supply provided in the plasma processing apparatus to be supplied with a voltage from the power supply connected thereto.

13. The plasma processing apparatus of claim 12, wherein the first coil and the second coil penetrate the processing chamber while being covered by a protection member and are connected to said one of the power supplies outside the processing chamber.

14. A plasma processing apparatus for performing plasma processing on a processing target in a processing chamber, comprising:
an object to be heated provided near a periphery of an upper electrode disposed in the processing chamber; and
a heating electrode disposed adjacent to the periphery of the upper electrode, for heating the object to be heated,
wherein a first coil having a first path and a second coil having a second path are wired close to each other in the heating electrode along the periphery of the upper electrode.

15. A heating electrode provided close to an object to be heated near a periphery of a mounting table installed in a plasma processing apparatus, wherein a first coil having a first path and a second coil having a second path are wired adjacent to each other along the periphery of the mounting table to heat the object to be heated.
